# EUROPEAN PATENT APPLICATION

(11) **EP 3 726 713 A1**
(43) Date of publication of application: **21.10.2020**
(21) Application number: 20169789.3
(22) Date of filing: 16.04.2020
(51) Int. Cl.: H02M 1/32, H01L 25/07, H01L 25/18

(54) **ELECTRIC POWER SUPPLY CIRCUIT AND ELECTRIC POWER SUPPLY DEVICE**

(30) Priority: 19.04.2019 JP 2019080176
(71) Applicant: JTEKT CORPORATION, Chuo-ku, Osaka-shi, Osaka 542-8502 (JP)
(72) Inventor: SATO, Fumihiko, Osaka-shi, Osaka 542-8502 (JP); OKUDA, Masataka, Toyota-shi, Aichi-ken, 471-8571 (JP); MIKIDA, Toshiyuki, Toyota-shi, Aichi-ken, 471-8571 (JP); HANZAWA, Hiroaki, Toyota-shi, Aichi-ken, 471-8571 (JP)
(74) Representative: Winter, Brandl, Fürniss, Hübner, Röss, Kaiser, Polte - Partnerschaft mbB

(57) **Abstract**

An electric power supply circuit includes an auxiliary electric power supply (100); a first MOSFET (101) provided on an auxiliary electric power supply-side feed path, the first MOSFET (101) including a parasitic diode configured to restrict conduction of electric current in a direction from the auxiliary electric power supply (100) toward the feed target; a second MOSFET (102) provided on the auxiliary electric power supply-side feed path, the second MOSFET (102) including a parasitic diode configured to restrict conduction of the electric current in a direction from the feed target toward the auxiliary electric power supply (100); and a third MOSFET (103) provided on at least one of the auxiliary electric power supply-side feed path and the main electric power supply-side feed path, the third MOSFET (103) including a parasitic diode configured to restrict conduction of the electric current in a direction from the main electric power supply toward the auxiliary electric power supply (100).

## Description

### BACKGROUND OF THE INVENTION

### 1. Field of the Invention

The invention relates to an electric power supply circuit and an electric power supply device.

### 2. Description of Related Art

Japanese Patent Application Publication No. 2008-302825 (JP 2008-302825 A) discloses an electric power supply circuit that backs up the feed (supply) of electric power to a feed target at the time of malfunction of a main electric power supply, with the use of an auxiliary electric power supply. The main electric power supply and the auxiliary electric power supply are connected in parallel to the feed target.

Japanese Patent Application Publication No. 2015-2634 (JP 2015-2634 A) discloses an electric power supply circuit. In this electric power supply circuit, a metal oxide semiconductor field effect transistor (MOSFET) for switching between a state where electric power is fed from a main electric power supply toward a feed target and a state where the feed of electric power is shut off, and a MOSFET for restricting the conduction of electric current in a direction from the feed target toward the main electric power supply are provided on a feed path from the main electric power supply to the feed target.

### SUMMARY OF THE INVENTION

In each of the above-mentioned electric power supply circuits, a first MOSFET and a second MOSFET may be provided on a feed path from the auxiliary electric power supply to the feed target. The first MOSFET switches between a state where electric power is fed from the auxiliary electric power supply to the feed target and the state where the feed of electric power is shut off. The second MOSFET restricts the conduction of electric current in the direction from the main electric power supply to the auxiliary electric power supply. In the case where the second MOSFET undergoes a short-circuit failure, even when the feed of electric power is shut off by the first MOSFET, electric current may flow from the main electric power supply to the auxiliary electric power supply.

A first aspect of the invention relates to an electric power supply circuit that is provided with a main electric power supply-side feed path as a feed path for feeding electric power from a main electric power supply to a feed target, and an auxiliary electric power supply-side feed path as a feed path for feeding the electric power from an auxiliary electric power supply to the feed target, the auxiliary electric power supply-side feed path being connected to the main electric power supply-side feed path. The electric power supply circuit includes the auxiliary electric power supply that is connected to the feed target through the auxiliary electric power supply-side feed path; a first MOSFET that is provided on the auxiliary electric power supply-side feed path, the first MOSFET including a parasitic diode configured to restrict conduction of electric current in a direction from the auxiliary electric power supply toward the feed target, and the first MOSFET being configured to switch between a fed state where the electric power is fed to the feed target and a shut-off state where feed of the electric power is shut off; a second MOSFET that is provided on the auxiliary electric power supply-side feed path, the second MOSFET including a parasitic diode configured to restrict conduction of the electric current in a direction from the feed target toward the auxiliary electric power supply, and the second MOSFET being configured to switch between the fed state where the electric power is fed to the feed target and the shut-off state where the feed of the electric power is shut off; and a third MOSFET that is provided on at least one of the auxiliary electric power supply-side feed path and the main electric power supply-side feed path, the third MOSFET including a parasitic diode configured to restrict conduction of the electric current in a direction from the main electric power supply toward the auxiliary electric power supply, the third MOSFET being configured to switch between the fed state where the electric power is fed to the feed target and the shut-off state where the feed of the electric power is shut off.

If the third MOSFET is not provided, when the second MOSFET undergoes a short-circuit failure, the second MOSFET conducts electric current in the direction from the main electric power supply toward the auxiliary electric power supply due to the short-circuit failure even in the case where the state of each of the second MOSFET and the first MOSFET is switched to the shut-off state. Further, the second MOSFET conducts electric current in the direction from the main electric power supply toward the auxiliary electric power supply through the parasitic diode. In this case, the flow of electric current from the main electric power supply into the auxiliary electric power supply cannot be restricted. With the above-mentioned configuration, the third MOSFET is provided on at least one of the auxiliary electric power supply-side feed path and the main electric power supply-side feed path, and the third MOSFET includes the parasitic diode configured to restrict the conduction of electric current in the direction from the main electric power supply toward the auxiliary electric power supply. Even if the second MOSFET undergoes a short-circuit failure, when the state of the third MOSFET is switched to the shut-off state, the conduction of electric current from the main electric power supply to the auxiliary electric power supply is shut off. Even in the case where the first MOSFET undergoes a short-circuit failure, when the state of each of the second MOSFET and the third MOSFET is switched to the shut-off state, the flow of electric current from the main electric power supply into the auxiliary electric power supply can be restricted. Even in the case where the third MOSFET undergoes a short-circuit failure, when the state of the second MOSFET is switched to the shut-off state, the flow of electric current from the main electric power supply into the auxiliary electric power supply can be restricted. In this manner, even in the case where one of the MOSFETs undergoes a short-circuit failure, the flow of electric current from the main electric power supply into the auxiliary electric power supply can be restricted.

In the electric power supply circuit according to the above-mentioned aspect, the third MOSFET may be provided on the auxiliary electric power supply-side feed path. With the above-mentioned configuration, the on-resistance during feeding of electric power from the main electric power supply to the feed target can be made smaller when the third MOSFET is provided on the auxiliary electric power supply-side feed path than when the third MOSFET is provided on the main electric power supply-side feed path.

In the electric power supply circuit according to the above-mentioned aspect, the auxiliary electric power supply-side feed path may include a first auxiliary electric power supply-side feed path and a second auxiliary electric power supply-side feed path; the first auxiliary electric power supply-side feed path and the second auxiliary electric power supply-side feed path may be provided in parallel with each other; the first MOSFET, the second MOSFET, and the third MOSFET may be provided on the first auxiliary electric power supply-side feed path; the electric power supply circuit may further include a fourth MOSFET that includes a parasitic diode configured to restrict the conduction of the electric current in the direction from the auxiliary electric power supply toward the feed target, the fourth MOSFET being configured to switch between the fed state where the electric power is fed to the feed target and the shut-off state where the feed of the electric power is shut off, a fifth MOSFET that includes a parasitic diode configured to restrict the conduction of the electric current in the direction from the feed target toward the auxiliary electric power supply, the fifth MOSFET being configured to switch between the fed state where the electric power is fed to the feed target and the shut-off state where the feed of the electric power is shut off, and a sixth MOSFET that includes a parasitic diode configured to restrict the conduction of the electric current in the direction from the main electric power supply toward the auxiliary electric power supply, the sixth MOSFET being configured to switch between the fed state where the electric power is fed to the feed target and the shut-off state where the feed of the electric power is shut off; and the fourth MOSFET, the fifth MOSFET, and the sixth MOSFET may be provided on the second auxiliary electric power supply-side feed path.

If there is no second auxiliary electric power supply-side feed path on which the fourth to sixth MOSFETs are provided, when the first MOSFET undergoes an open failure, electric current cannot be conducted from the auxiliary electric power supply to the feed target even in the case where the state of each of the second MOSFET and the third MOSFET is switched to the fed state. In this case, even when an attempt is made to feed electric power from the auxiliary electric power supply, electric power cannot be fed to the feed target. With the above-mentioned configuration, the second auxiliary electric power supply-side feed path is provided between the auxiliary electric power supply and the feed target, separately from the first auxiliary electric power supply-side feed path. Therefore, when the first MOSFET undergoes an open failure, electric power can be fed from the auxiliary electric power supply to the feed target through the second auxiliary electric power supply-side feed path. When the fourth MOSFET undergoes an open failure, electric power can be fed from the auxiliary electric power supply to the feed target through the first auxiliary electric power supply-side feed path. When one of the second MOSFET, the third MOSFET, the fifth MOSFET, and the sixth MOSFET undergoes an open failure, electric power can be fed from the auxiliary electric power supply to the feed target through at least one of the first auxiliary electric power supply-side feed path and the second auxiliary electric power supply-side feed path. In this manner, even when one of the MOSFETs undergoes an open failure, the conduction of electric current from the auxiliary electric power supply to the feed target can be realized.

In the electric power supply circuit according to the above-mentioned aspect, the main electric power supply-side feed path may include a first main electric power supply-side feed path and a second main electric power supply-side feed path; the first main electric power supply-side feed path and the second main electric power supply-side feed path may be provided in parallel with each other; a seventh MOSFET and an eighth MOSFET may be provided on the first main electric power supply-side feed path, the seventh MOSFET including a parasitic diode configured to restrict conduction of the electric current in a direction from the main electric power supply toward the feed target, the seventh MOSFET being configured to switch between the fed state where the electric power is fed to the feed target and the shut-off state where the feed of the electric power is shut off, the eighth MOSFET including a parasitic diode configured to restrict conduction of the electric current in a direction from the feed target toward the main electric power supply, and the eighth MOSFET being configured to switch between the fed state where the electric power is fed to the feed target and the shut-off state where the feed of the electric power is shut off; and a ninth MOSFET and a tenth MOSFET may be provided on the second main electric power supply-side feed path, the ninth MOSFET including a parasitic diode configured to restrict the conduction of the electric current in the direction from the main electric power supply toward the feed target, the ninth MOSFET being configured to switch between the fed state where the electric power is fed to the feed target and the shut-off state where the feed of the electric power is shut off, the tenth MOSFET including a parasitic diode configured to restrict the conduction of the electric current in the direction from the feed target toward the main electric power supply, the tenth MOSFET being configured to switch between the fed state where the electric power is fed to the feed target and the shut-off state where the feed of the electric power is shut off.

With the above-mentioned configuration, even when one of the seventh to tenth MOSFETs undergoes a short-circuit failure, the flow of electric current from the main electric power supply into the auxiliary electric power supply can be restricted. Even when one of the seventh to tenth MOSFETs undergoes an open failure, the conduction of electric current from the main electric power supply to the feed target can be realized.

A second aspect of the invention relates to an electric power supply device. The electric power supply device includes the electric power supply circuit; and a control unit configured to control switching between the fed state and the shut-off state. The feed target is a steering system configured to apply power to a steering mechanism of a vehicle.

With the above-mentioned configuration, it is possible to provide the electric power supply device that can restrict the flow of electric current from the main electric power supply into the auxiliary electric power supply even when one of the MOSFETs undergoes a short-circuit failure.

The electric power supply circuit and the electric power supply device according to the above-mentioned aspects of the invention can restrict the flow of electric current from the main electric power supply into the auxiliary electric power supply when electric power is fed from the main electric power supply to the feed target.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a view schematically showing the configuration of a steering system provided with an electric power supply device;
FIG. 2 is a view showing the electric configuration of the electric power supply device;
FIG. 3 is a table showing switching states of respective MOSFETs of the electric power supply device;
FIG. 4 is a circuit diagram showing switching states of the respective MOSFETs of the electric power supply device in the case where a main electric power supply does not malfunction and the seventh MOSFET undergoes an open failure; and
FIG. 5 is a circuit diagram showing switching states of the respective MOSFETs of the electric power supply device in the case where the main electric power supply does not malfunction and the second MOSFET undergoes a short-circuit failure.

### DETAILED DESCRIPTION OF EMBODIMENTS

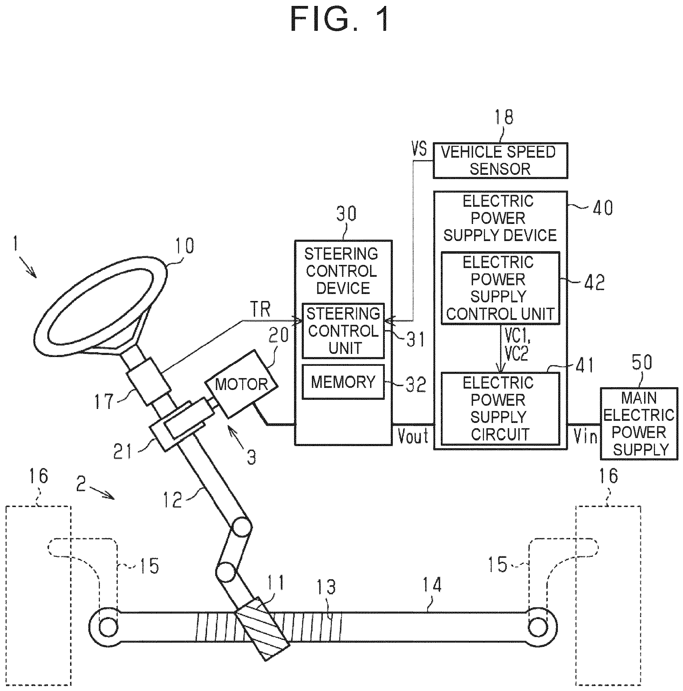

An embodiment in which an electric power supply circuit and an electric power supply device are applied to a steering system will be described. As shown in FIG. 1, a steering system 1 of the present embodiment includes a steering mechanism 2 that turns turning wheels 16 based on a driver's operation of a steering wheel 10, and an assist mechanism 3 including a motor 20 that assists the driver in performing a steering operation. The steering system 1 is a so-called electric power steering system that assists the driver in performing the steering operation by applying a motor torque of the motor 20 to the steering mechanism 2 as a steering assist force.

The steering mechanism 2 includes a steering shaft 12 including one end to which the steering wheel 10 is fixed and the other end at which a pinion gear 11 is formed, and a rack shaft 14 on which a rack gear 13 that meshes with the pinion gear 11 is formed. This pinion gear 11 and this rack gear 13 constitute a rack-and-pinion mechanism. A rotational movement of the steering shaft 12 is converted into a reciprocating linear movement of the rack shaft 14 in an axial direction thereof via the rack-and-pinion mechanism. The steering system 1 is mounted in a vehicle such that the axial direction of the rack shaft 14 coincides with a vehicle width direction. The reciprocating linear movement of the rack shaft 14 is transmitted to the right and left turning wheels 16 via tie rods 15 coupled to both ends of the rack shaft 14, respectively. Thus, the turning angle of each of the turning wheels 16 changes, and the traveling direction of the vehicle is changed.

The steering shaft 12 is provided with a torque sensor 17 configured to measure a steering torque TR applied to the steering shaft 12 through operation of the steering wheel 10. The torque sensor 17 of the present embodiment detects a torsion amount of a torsion bar that constitutes a part of the steering shaft 12. The torque sensor 17 measures the steering torque TR based on the torsion amount.

The assist mechanism 3 includes the motor 20 for steering assist, and a reducer 21. The motor 20 is coupled to the steering shaft 12 via the reducer 21. The reducer 21 reduces the speed of rotation of the motor 20, and transmits a rotational force to the steering shaft 12 after the speed of the rotation is reduced. A three-phase brushless motor is adopted as the motor 20 of the present embodiment. A worm gear mechanism is adopted as the reducer 21 of the present embodiment.

The steering system 1 includes a steering control device 30 and an electric power supply device 40. An inverter as a known circuit that includes two switching elements for each of phases (a U-phase, a V-phase, and a W-phase) of the motor 20 is provided in the steering control device 30. When the steering system 1 is mounted in the vehicle, the electric power supply device 40 is connected to an in-vehicle main electric power supply 50, and the steering control device 30 is connected to the main electric power supply 50 via the electric power supply device 40. The electric power supply device 40 is provided between the main electric power supply 50 and the steering control device 30 as one of components of the steering system 1 to which electric power is fed. The steering control device 30 assists the driver in performing the steering operation by controlling the operation of the motor 20 through the feed of electric power from the main electric power supply 50. The steering control device 30 includes a steering control unit 31 that performs various kinds of computing processing for computing controlled variables and the like for controlling the operation of the motor 20, and a memory 32 that stores programs and data for the various kinds of computing processing. The above-mentioned torque sensor 17 and a vehicle speed sensor 18 are connected to the steering control unit 31. The vehicle speed sensor 18 detects a running speed VS of the vehicle. The steering control unit 31 determines a steering assist force corresponding to a target steering assist force as a target value of the steering assist force based on the steering torque TR and the running speed VS, when controlling the steering assist force. The steering control unit 31 controls the operation of the motor 20 through control of the inverter, so as to generate the steering assist force corresponding to the target steering assist force.

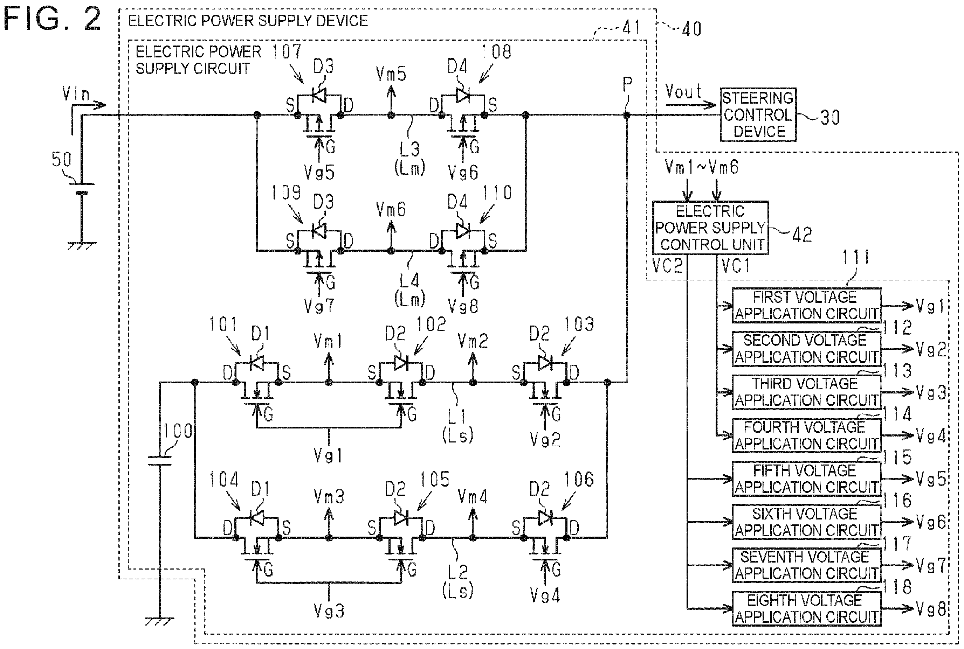

The function of the electric power supply device 40 will be described. As shown in FIG. 2, the electric power supply device 40 includes an electric power supply circuit 41 and an electric power supply control unit 42.

The electric power supply circuit 41 has the function of changing the state between the main electric power supply 50 and the steering control device 30, or between an auxiliary electric power supply 100 and the steering control device 30. That is, the electric power supply circuit 41 has the function of switching between a fed state where electric power is fed to the steering control device 30 and a shut-off state where the feed of electric power is shut off. An electric power supply voltage of the main electric power supply 50 is input to the electric power supply circuit 41 as an input voltage Vin. The electric power supply circuit 41 outputs the input voltage Vin input thereto as an output voltage Vout, and thus, the electric power supply circuit 41 supplies the output voltage Vout to the steering control device 30.

The electric power supply control unit 42 has the function of controlling the switching between the fed state of the electric power supply circuit 41 and the shut-off state of the electric power supply circuit 41. Although not shown in the drawing, the electric power supply voltage of the main electric power supply 50 is input to the electric power supply control unit 42 as the input voltage Vin, and the switching between the fed state of the electric power supply circuit 41 and the shut-off state of the electric power supply circuit 41 is controlled based on the input voltage Vin thus input to the electric power supply control unit 42. The electric power supply control unit 42 outputs control voltages VC1 and VC2 to switch between the fed state of the electric power supply circuit 41 and the shut-off state of the electric power supply circuit 41. In the present embodiment, the electric power supply control unit 42 is an example of the control unit. The electric power supply control unit 42 is an electronic control unit (ECU) including a processor, and so on.

The function of the electric power supply circuit 41 will be described. As shown in FIG. 2, the electric power supply circuit 41 includes the auxiliary electric power supply 100, 10 metal oxide semiconductor field effect transistors (MOSFETs), and eight voltage application circuits. The auxiliary electric power supply 100 can be charged with electric charges, and can discharge electric charges. For example, a lithium-ion capacitor is adopted as the auxiliary electric power supply 100. The output voltage of the auxiliary electric power supply 100 is set to be equal to or lower than the electric power supply voltage of the main electric power supply 50.

The electric power supply circuit 41 is provided with a main electric power supply-side feed path Lm as a feed path for feeding electric power to the steering control device 30 serving as a feed target from the main electric power supply 50, and an auxiliary electric power supply-side feed path Ls as a feed path from the auxiliary electric power supply 100 to the steering control device 30. The auxiliary electric power supply-side feed path Ls is connected to the main electric power supply-side feed path Lm. The auxiliary electric power supply-side feed path Ls is connected to a connection point P on the main electric power supply-side feed path Lm. The auxiliary electric power supply-side feed path Ls includes a first auxiliary electric power supply-side feed path L1 and a second auxiliary electric power supply-side feed path L2. The first auxiliary electric power supply-side feed path L1 and the second auxiliary electric power supply-side feed path L2 are provided in parallel with each other. The main electric power supply-side feed path Lm includes a first main electric power supply-side feed path L3 and a second main electric power supply-side feed path L4. The first main electric power supply-side feed path L3 and the second main electric power supply-side feed path L4 are provided in parallel with each other. The first main electric power supply-side feed path L3 and the second main electric power supply-side feed path L4 are connected in parallel with each other at a position closer to the main electric power supply 50 than the connection point P is.

The electric power supply circuit 41 includes first to sixth MOSFETs 101 to 106 that are provided on the auxiliary electric power supply-side feed path Ls, and seventh to tenth MOSFETs 107 to 110 that are provided on the main electric power supply-side feed path Lm. Each of the first to sixth MOSFETs 101 to 106 is an N-channel MOSFET including a source terminal with which an N-type semiconductor layer is associated, a drain terminal with which an N-type semiconductor layer is associated, and a gate terminal with which a P-type semiconductor layer is associated. In FIG. 2, each source terminal is denoted by "S", each drain terminal is denoted by "D", and each gate terminal is denoted by "G". Each of the seventh to tenth MOSFETs 107 to 110 is a P-channel MOSFET including a source terminal with which a P-type semiconductor layer is associated, a drain terminal with which a P-type semiconductor layer is associated, and a gate terminal with which an N-type semiconductor layer is associated.

The first MOSFET 101, the second MOSFET 102, and the third MOSFET 103 are provided on the first auxiliary electric power supply-side feed path L1. The drain terminal of the first MOSFET 101 is connected to a high potential side of the auxiliary electric power supply 100, and the source terminal of the first MOSFET 101 is connected to the source terminal of the second MOSFET 102. A parasitic diode D1 of the first MOSFET 101 shuts off the conduction of electric current from the drain terminal to the source terminal. A parasitic diode of each of the second to sixth MOSFETs 102 to 106, which will be described later, also shuts off the conduction of electric current from the drain terminal to the source terminal. The parasitic diode D1 of the first MOSFET 101 restricts the conduction of electric current in the direction from the auxiliary electric power supply 100 toward the steering control device 30.

The source terminal of the second MOSFET 102 is connected to the source terminal of the first MOSFET 101, and the drain terminal of the second MOSFET 102 is connected to the source terminal of the third MOSFET 103. The gate terminal of the first MOSFET 101 and the gate terminal of the second MOSFET 102 are connected to a first voltage application circuit 111. A parasitic diode D2 of the second MOSFET 102 restricts the conduction of electric current in the direction from the steering control device 30 toward the auxiliary electric power supply 100.

The source terminal of the third MOSFET 103 is connected to the drain terminal of the second MOSFET 102, and the drain terminal of the third MOSFET 103 is connected to the steering control device 30. The gate terminal of the third MOSFET 103 is connected to a second voltage application circuit 112. The parasitic diode D2 of the third MOSFET 103 restricts the conduction of electric current in the direction from the steering control device 30 toward the auxiliary electric power supply 100.

The fourth MOSFET 104, the fifth MOSFET 105, and the sixth MOSFET 106 are provided on the second auxiliary electric power supply-side feed path L2. The drain terminal of the fourth MOSFET 104 is connected to the high potential side of the auxiliary electric power supply 100, and the source terminal of the fourth MOSFET 104 is connected to the source terminal of the fifth MOSFET 105. The parasitic diode D1 of the fourth MOSFET 104 restricts the conduction of electric current in the direction from the auxiliary electric power supply 100 toward the steering control device 30.

The source terminal of the fifth MOSFET 105 is connected to the source terminal of the fourth MOSFET 104, and the drain terminal of the fifth MOSFET 105 is connected to the source terminal of the sixth MOSFET 106. The gate terminal of the fourth MOSFET 104 and the gate terminal of the fifth MOSFET 105 are connected to a third voltage application circuit 113. The parasitic diode D2 of the fifth MOSFET 105 restricts the conduction of electric current in the direction from the steering control device 30 toward the auxiliary electric power supply 100.

The source terminal of the sixth MOSFET 106 is connected to the drain terminal of the fifth MOSFET 105, and the drain terminal of the sixth MOSFET 106 is connected to the steering control device 30. The gate terminal of the sixth MOSFET 106 is connected to a fourth voltage application circuit 114. The parasitic diode D2 of the sixth MOSFET 106 restricts the conduction of electric current in the direction from the steering control device 30 toward the auxiliary electric power supply 100.

The seventh MOSFET 107 and the eighth MOSFET 108 are provided on the first main electric power supply-side feed path L3. The source terminal of the seventh MOSFET 107 is connected to a high potential side of the main electric power supply 50, and the drain terminal of the seventh MOSFET 107 is connected to the drain terminal of the eighth MOSFET 108. The gate terminal of the seventh MOSFET 107 is connected to a fifth voltage application circuit 115. A parasitic diode D3 of the seventh MOSFET 107 shuts off the conduction of electric current from the source terminal to the drain terminal. Aparasitic diode of each of the eighth to tenth MOSFETs 108 to 110, which will be described later, also shuts off the conduction of electric current from the source terminal to the drain terminal. The parasitic diode D3 of the seventh MOSFET 107 restricts the conduction of electric current in the direction from the main electric power supply 50 toward the steering control device 30.

The drain terminal of the eighth MOSFET 108 is connected to the drain terminal of the seventh MOSFET 107, and the source terminal of the eighth MOSFET 108 is connected to the steering control device 30. The gate terminal of the eighth MOSFET 108 is connected to a sixth voltage application circuit 116. A parasitic diode D4 of the eighth MOSFET 108 restricts the conduction of electric current in the direction from the steering control device 30 toward the main electric power supply 50.

The ninth MOSFET 109 and the tenth MOSFET 110 are provided on the second main electric power supply-side feed path L4. The source terminal of the ninth MOSFET 109 is connected to the high potential side of the main electric power supply 50, and the drain terminal of the ninth MOSFET 109 is connected to the drain terminal of the tenth MOSFET 110. The gate terminal of the ninth MOSFET 109 is connected to a seventh voltage application circuit 117. The parasitic diode D3 of the ninth MOSFET 109 restricts the conduction of electric current in the direction from the main electric power supply 50 toward the steering control device 30.

The drain terminal of the tenth MOSFET 110 is connected to the drain terminal of the ninth MOSFET 109, and the source terminal of the tenth MOSFET 110 is connected to the steering control device 30. The gate terminal of the tenth MOSFET 110 is connected to an eighth voltage application circuit 118. The parasitic diode D4 of the tenth MOSFET 110 restricts the conduction of electric current in the direction from the steering control device 30 toward the main electric power supply 50.

The electric power supply circuit 41 includes the first to fourth voltage application circuits 111 to 114 that change switching states of the first to sixth MOSFETs 101 to 106 that are provided on the auxiliary electric power supply-side feed path Ls, and the fifth to eighth voltage application circuits 115 to 118 that change switching states of the seventh to tenth MOSFETs 107 to 110 that are provided on the main electric power supply-side feed path Lm. The first to eighth voltage application circuits 111 to 118 are connected to the electric power supply control unit 42. In order to change each of the switching states between a fed state and a shut-off state, the electric power supply control unit 42 outputs a control voltage VC1 to each of the first to fourth voltage application circuits 111 to 114, and outputs a control voltage VC2 to each of the fifth to eighth voltage application circuits 115 to 118. More specifically, when the main electric power supply 50 does not malfunction, the electric power supply control unit 42 outputs the control voltage VC2 for feed switching (i.e., for switching to the fed state) for bringing each of the seventh to tenth MOSFETs 107 to 110 on the main electric power supply-side feed path Lm to the fed state, so as to cause the steering control device 30 to perform the control regarding application of a steering assist force based on the feed of electric power from the main electric power supply 50. On the other hand, when the main electric power supply 50 does not malfunction, the electric power supply control unit 42 outputs the control voltage VC1 for shut-off switching (i.e., for switching to the shut-off state) for bringing each of the first to sixth MOSFETs 101 to 106 on the auxiliary electric power supply-side feed path Ls to the shut-off state. When the main electric power supply 50 malfunctions, the electric power supply control unit 42 outputs the control voltage VC1 for feed switching for bringing each of the first to sixth MOSFETs 101 to 106 on the auxiliary electric power supply-side feed path Ls to the fed state, so as to cause the steering control device 30 to perform the control regarding application of a steering assist force based on the feed of electric power from the auxiliary electric power supply 100. On the other hand, when the main electric power supply 50 malfunctions, the electric power supply control unit 42 outputs the control voltage VC2 for shut-off switching for bringing each of the seventh to tenth MOSFETs 107 to 110 on the main electric power supply-side feed path Lm to the shut-off state. Each of the control voltages VC1 and VC2 for feed switching is a control voltage for bringing each of the MOSFETs to the fed state, and each of the control voltages VC1 and VC2 for shut-off switching is a control voltage for bringing each of the MOSFETs to the shut-off state. In the present embodiment, the control voltage VC2 for feed switching for bringing each of the seventh to tenth MOSFETs 107 to 110 to the fed state is a low-level signal that is lower in potential than the control voltage VC2 for shut-off switching for bringing each of the seventh to tenth MOSFETs 107 to 110 to the shut-off state. On the other hand, the control voltage VC1 for feed switching for bringing each of the first to sixth MOSFETs 101 to 106 to the fed state is a high-level signal that is higher in potential than the control voltage VC1 for shut-off switching for bringing each of the first to sixth MOSFETs 101 to 106 to the shut-off state.

When the control voltage VC1 for feed switching is input to the first voltage application circuit 111 from the electric power supply control unit 42, the first voltage application circuit 111 applies a gate voltage Vg1 to the gate terminal of each of the first MOSFET 101 and the second MOSFET 102 such that the difference between the potential of the source terminal and the potential of the gate terminal becomes equal to or larger than a set threshold while the potential of the gate terminal is higher than the potential of the source terminal. This threshold is approximately set to a value at which an inversion layer is formed on the P-type semiconductor layer that is associated with the gate terminal. When the control voltage VC1 for shut-off switching is input to the first voltage application circuit 111 from the electric power supply control unit 42, the first voltage application circuit 111 applies the gate voltage Vg1 to the gate terminal of each of the first MOSFET 101 and the second MOSFET 102 such that the difference between the potential of the source terminal and the potential of the gate terminal becomes smaller than a set threshold so that the potential of the source terminal and the potential of the gate terminal become equal to each other. Each of the first MOSFET 101 and the second MOSFET 102 as the N-channel MOSFETs has the following characteristic. Each of the first MOSFET 101 and the second MOSFET 102 is in the shut-off state where the conduction of electric current between the source terminal and the drain terminal is shut off when the difference between the potential of the source terminal and the potential of the gate terminal is smaller than the threshold. Each of the first MOSFET 101 and the second MOSFET 102 as the N-channel MOSFETs also has the following characteristic. Each of the first MOSFET 101 and the second MOSFET 102 is in the fed state where the conduction of electric current between the source terminal and the drain terminal is permitted when the difference between the potential of the source terminal and the potential of the gate terminal is equal to or larger than the set threshold while the potential of the gate terminal is higher than the potential of the source terminal.

The second voltage application circuit 112, the third voltage application circuit 113, and the fourth voltage application circuit 114 function in the same manner as the manner in which the first voltage application circuit 111 functions when the control voltage VC1 for feed switching or the control voltage VC1 for shut-off switching is input thereto from the electric power supply control unit 42, and thus, the description thereof will be omitted. The second voltage application circuit 112 changes the switching state of the third MOSFET 103 between the fed state and the shut-off state. The third voltage application circuit 113 changes the switching state of each of the fourth MOSFET 104 and the fifth MOSFET 105 between the fed state and the shut-off state. The fourth voltage application circuit 114 changes the switching state of the sixth MOSFET 106 between the fed state and the shut-off state.

When the control voltage VC2 for feed switching is input to the fifth voltage application circuit 115 from the electric power supply control unit 42, the fifth voltage application circuit 115 applies a gate voltage Vg5 to the gate terminal of the seventh MOSFET 107 such that the difference between the potential of the source terminal and the potential of the gate terminal becomes equal to or larger than a set threshold while the potential of the gate terminal is lower than the potential of the source terminal. This threshold is approximately set to a value at which an inversion layer is formed on the N-type semiconductor layer associated with the gate terminal of the P-channel MOSFET. When the control voltage VC2 for shut-off switching is input to the fifth voltage application circuit 115 from the electric power supply control unit 42, the fifth voltage application circuit 115 applies the gate voltage Vg5 to the gate terminal of the seventh MOSFET 107 such that the difference between the potential of the source terminal and the potential of the gate terminal becomes smaller than a set threshold so that the potential of the source terminal and the potential of the gate terminal become equal to each other. The seventh MOSFET 107 as the P-channel MOSFET has the following characteristic. The seventh MOSFET 107 is in the shut-off state where the conduction of electric current between the source terminal and the drain terminal is shut off when the difference between the potential of the source terminal and the potential of the gate terminal is smaller than the threshold. The seventh MOSFET 107 as the P-channel MOSFET also has the following characteristic. The seventh MOSFET 107 is in the fed state where the conduction of electric power between the source terminal and the drain terminal is permitted when the difference between the potential of the source terminal and the potential of the gate terminal is equal to or larger than the threshold while the potential of the gate terminal is lower than the potential of the source terminal.

The sixth voltage application circuit 116, the seventh voltage application circuit 117, and the eighth voltage application circuit 118 function in the same manner as the manner in which the fifth voltage application circuit 115 functions when the control voltage VC2 for feed switching or the control voltage VC2 for shut-off switching is input thereto from the electric power supply control unit 42, and thus, the description thereof will be omitted. The sixth voltage application circuit 116 changes the switching state of the eighth MOSFET 108 between the fed state and the shut-off state. The seventh voltage application circuit 117 changes the switching state of the ninth MOSFET 109 between the fed state and the shut-off state. The eighth voltage application circuit 118 changes the switching state of the tenth MOSFET 110 between the fed state and the shut-off state.

The electric power supply control unit 42 acquires an intermediate potential Vm1 between the first MOSFET 101 and the second MOSFET 102 on the first auxiliary electric power supply-side feed path L1, and an intermediate potential Vm2 between the second MOSFET 102 and the third MOSFET 103 on the first auxiliary electric power supply-side feed path L1. The electric power supply control unit 42 acquires an intermediate potential Vm3 between the fourth MOSFET 104 and the fifth MOSFET 105 on the second auxiliary electric power supply-side feed path L2, and an intermediate potential Vm4 between the fifth MOSFET 105 and the sixth MOSFET 106 on the second auxiliary electric power supply-side feed path L2. The electric power supply control unit 42 acquires an intermediate potential Vm5 between the seventh MOSFET 107 and the eighth MOSFET 108 on the first main electric power supply-side feed path L3, and an intermediate potential Vm6 between the ninth MOSFET 109 and the tenth MOSFET 110 on the second main electric power supply-side feed path L4. The electric power supply control unit 42 makes a determination on abnormalities of the first to tenth MOSFETs 101 to 110 based on these intermediate potentials Vm1 to Vm6. A short-circuit failure with a constant conductive state between the source terminal and the drain terminal, and an open failure with a constant shut-off state between the source terminal and the drain terminal can be mentioned as the abnormalities of the first to tenth MOSFETs 101 to 110. As an example of determining whether or not the first to tenth MOSFETs 101 to 110 are abnormal, it is determined that the seventh MOSFET 107 undergoes an open failure when the intermediate potential Vm5 is equal to 0V and the intermediate potential Vm6 is equal in potential to the electric power supply voltage of the main electric power supply 50 in the case where the seventh to tenth MOSFETs 107 to 110 are in the fed state. As another example of determining whether or not the first to tenth MOSFETs 101 to 110 are abnormal, it is determined that the first MOSFET 101 undergoes a short-circuit failure when the intermediate potential Vm1 is equal in potential to the output voltage of the auxiliary electric power supply 100 in the case where the first to sixth MOSFETs 101 to 106 are in the shut-off state. By using the intermediate potentials Vm1 to Vm6 in this manner, it is possible to determine whether or not the first to tenth MOSFETs 101 to 110 are abnormal. It is determined whether or not the first to tenth MOSFETs 101 to 110 are abnormal, during an initial check that is carried out when a switch for starting the vehicle is turned on. The electric power supply control unit 42 determines, based on the intermediate potentials Vm1 to Vm6, whether or not the main electric power supply 50 malfunctions, and whether or not the auxiliary electric power supply 100 malfunctions. The electric power supply control unit 42 determines that the main electric power supply 50 malfunctions when it is indicated that both the intermediate potentials Vm5 and Vm6 are lower than a voltage that is needed for the steering control device 30 to perform the control regarding application of a steering assist force in the case where the seventh to tenth MOSFETs 107 to 110 are in the fed state. The electric power supply control unit 42 determines that the auxiliary electric power supply 100 malfunctions when it is indicated that the intermediate potentials Vm1 to Vm4 are all lower than the voltage that is needed for the steering control device 30 to perform the control regarding application of a steering assist force in the case where the first to sixth MOSFETs 101 to 106 are in the fed state. It is intermittently determined whether or not the main electric power supply 50 and the auxiliary electric power supply 100 malfunction, during a period in which the switch for starting the vehicle is on.

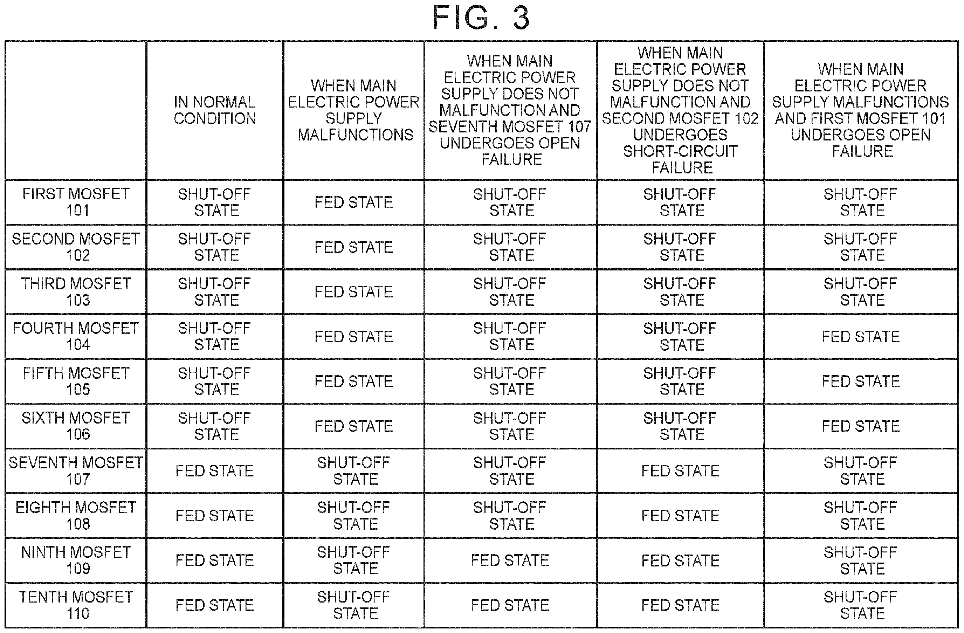

The operation of the present embodiment will be described. As shown in FIGS. 2 and 3, in the normal condition, namely, when the main electric power supply 50 does not malfunction and there is no abnormality in the function of the electric power supply circuit 41, the electric power supply control unit 42 changes the state of each of the first to sixth MOSFETs 101 to 106 to the shut-off state, and changes the state of each of the seventh to tenth MOSFETs 107 to 110 to the fed state, so as to feed electric power from the main electric power supply 50 to the steering control device 30. Thus, electric power is fed from the main electric power supply 50 to the steering control device 30 through the first main electric power supply-side feed path L3 and the second main electric power supply-side feed path L4.

In the case where there is no abnormality in the function of the electric power supply circuit 41 when the main electric power supply 50 malfunctions, the electric power supply control unit 42 changes the state of each of the first to sixth MOSFETs 101 to 106 to the fed state, and changes the state of each of the seventh to tenth MOSFETs 107 to 110 to the shut-off state, so as to feed electric power from the auxiliary electric power supply 100 to the steering control device 30. Thus, electric power can be fed from the auxiliary electric power supply 100 to the steering control device 30 through the first auxiliary electric power supply-side feed path L1 and the second auxiliary electric power supply-side feed path L2. Therefore, the feed of electric power to the steering control device 30 at the time of malfunction of the main electric power supply 50 can be backed up.

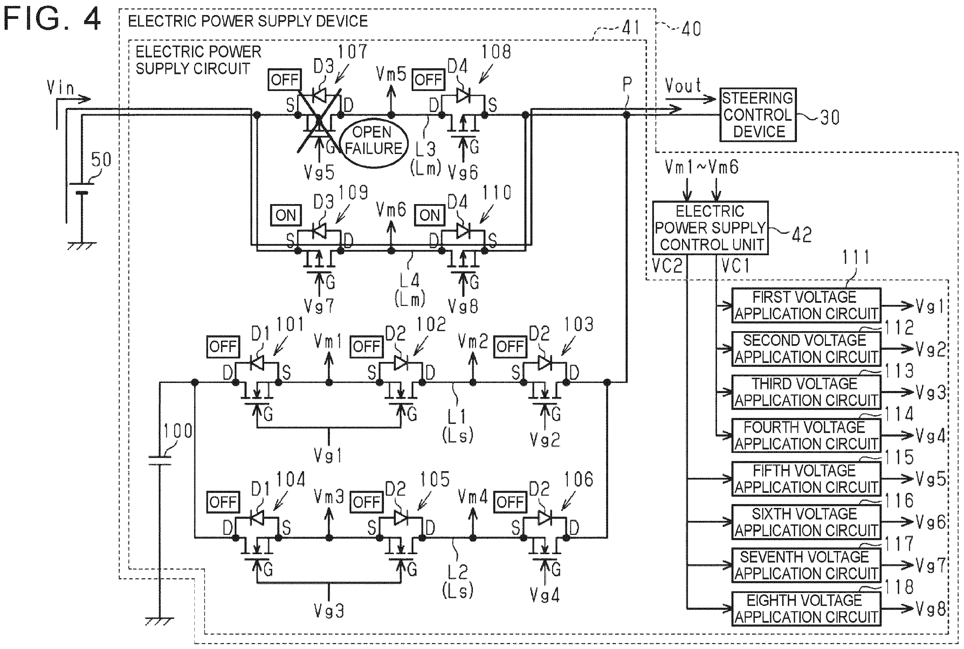

As shown in FIGS. 3 and 4, for example, when the main electric power supply 50 does not malfunction and the seventh MOSFET 107 undergoes an open failure, the electric power supply control unit 42 changes the state of each of the first to eighth MOSFETs 101 to 108 to the shut-off state, and changes the state of each of the ninth MOSFET 109 and the tenth MOSFET 110 to the fed state. Thus, even when the source terminal of the seventh MOSFET 107 and the drain terminal of the seventh MOSFET 107 are constantly shut off from each other due to the open failure of the seventh MOSFET 107, electric power can be fed from the main electric power supply 50 to the steering control device 30 through the second main electric power supply-side feed path L4. As shown in FIG. 2, for example, when the main electric power supply 50 does not malfunction and the eighth MOSFET 108 undergoes an open failure, the source terminal of the eighth MOSFET 108 and the drain terminal of the eighth MOSFET 108 are constantly shut off from each other, but electric power is conducted in the direction from the main electric power supply 50 toward the steering control device 30 through the parasitic diode D4 of the eighth MOSFET 108. Thus, when the eighth MOSFET 108 undergoes an open malfunction, electric power can be fed from the main electric power supply 50 to the steering control device 30 through the first main electric power supply-side feed path L3 and the second main electric power supply-side feed path L4. For example, when the main electric power supply 50 does not malfunction and the ninth MOSFET 109 undergoes an open failure, the electric power supply control unit 42 changes the state of each of the first to sixth MOSFETs 101 to 106, the ninth MOSFET 109, and the tenth MOSFET 110 to the shut-off state, and changes the state of each of the seventh MOSFET 107 and the eighth MOSFET 108 to the fed state. Thus, electric power can be fed from the main electric power supply 50 to the steering control device 30 through the first main electric power supply-side feed path L3. For example, the main electric power supply 50 does not malfunction, and electric current is conducted in the direction from the main electric power supply 50 toward the steering control device 30 through the parasitic diode D4 of the tenth MOSFET 110, and thus, the electric power supply control unit 42 can feed electric power from the main electric power supply 50 to the steering control device 30 through the first main electric power supply-side feed path L3 and the second main electric power supply-side feed path L4.

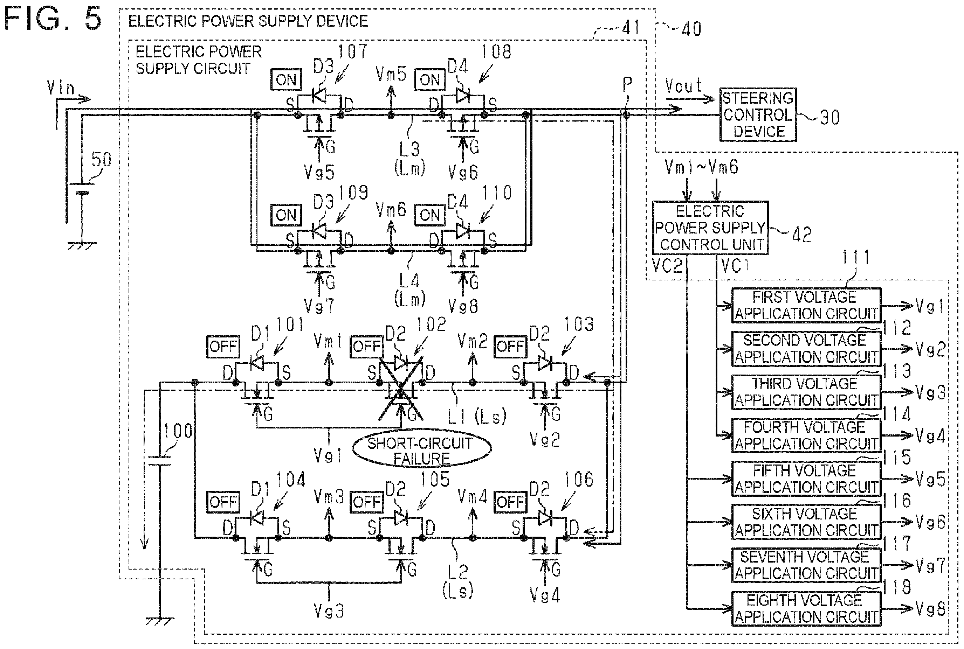

As shown in FIGS. 3 and 5, for example, when the main electric power supply 50 does not malfunction and the second MOSFET 102 undergoes a short-circuit failure, the electric power supply control unit 42 changes the state of each of the first to sixth MOSFETs 101 to 106 to the shut-off state, and changes the state of each of the seventh to tenth MOSFETs 107 to 110 to the fed state. In this case, even when the source terminal of the second MOSFET 102 and the drain terminal of the second MOSFET 102 are constantly conductive to each other due to the short-circuit failure of the second MOSFET 102, the flow of electric current from the main electric power supply 50 into the auxiliary electric power supply 100 can be restricted by changing the state of the third MOSFET 103 to the shut-off state. That is, in the normal condition as well as when the main electric power supply 50 does not malfunction and one of the first to tenth MOSFETs 101 to 110 undergoes a short-circuit failure, the electric power supply control unit 42 changes the state of each of the first to sixth MOSFETs 101 to 106 to the shut-off state, and changes the state of each of the seventh to tenth MOSFETs 107 to 110 to the fed state. Thus, the flow of electric current from the main electric power supply 50 into the auxiliary electric power supply 100 can be restricted. For example, when the main electric power supply 50 does not malfunction and the first MOSFET 101 undergoes a short-circuit failure, the flow of electric current from the main electric power supply 50 into the auxiliary electric power supply 100 can be restricted by changing the state of each of the second MOSFET 102 and the third MOSFET 103 to the shut-off state. For example, when the main electric power supply 50 does not malfunction and the third MOSFET 103 undergoes a short-circuit failure, the flow of electric current from the main electric power supply 50 into the auxiliary electric power supply 100 can be restricted by changing the state of the second MOSFET 102 to the shut-off state.

As shown in FIGS. 2 and 3, for example, when the main electric power supply 50 malfunctions and the first MOSFET 101 undergoes an open failure, the electric power supply control unit 42 changes the state of each of the first to third MOSFETs 101 to 103 and the seventh to tenth MOSFETs 107 to 110 to the shut-off state, and changes the state of each of the fourth to sixth MOSFETs 104 to 106 to the fed state. In this case, even when the source terminal of the first MOSFET 101 and the drain terminal of the first MOSFET 101 are constantly shut off from each other due to the open failure of the first MOSFET 101, electric power can be fed from the auxiliary electric power supply 100 to the steering control device 30 through the second auxiliary electric power supply-side feed path L2. Thus, the feed of electric power to the steering control device 30 at the time of malfunction of the main electric power supply 50 can be backed up. As shown in FIG. 2, for example, when the main electric power supply 50 malfunctions and the second MOSFET 102 or the third MOSFET 103 undergoes an open failure as well, the electric power supply control unit 42 brings each of the first to third MOSFETs 101 to 103 and the seventh to tenth MOSFETs 107 to 110 to the shut-off state, and brings each of the fourth to sixth MOSFETs 104 to 106 to the fed state. Thus, electric power can be fed from the auxiliary electric power supply 100 to the steering control device 30 through the second auxiliary electric power supply-side feed path L2. On the other hand, for example, when the main electric power supply 50 malfunctions and one of the fourth to sixth MOSFETs 104 to 106 undergoes an open failure, the electric power supply control unit 42 brings each of the fourth to tenth MOSFETs 104 to 110 to the shut-off state, and brings each of the first to third MOSFETs 101 to 103 to the fed state. Thus, electric power can be fed from the auxiliary electric power supply 100 to the steering control device 30 through the first auxiliary electric power supply-side feed path L1.

As shown in FIG. 2, when the auxiliary electric power supply 100 malfunctions while the main electric power supply 50 does not malfunction, the electric power supply control unit 42 performs the same control as in the above-mentioned case. When both the main electric power supply 50 and the auxiliary electric power supply 100 malfunction, the electric power supply control unit 42 cannot obtain a voltage that is needed for the steering control device 30 to perform the control regarding application of a steering assist force, and thus proceeds to failsafe operation such as the ending of control or the like.

The effects of the present embodiment will be described.
(1) If the third MOSFET 103 is not provided, when the second MOSFET 102 undergoes a short-circuit failure, the second MOSFET 102 conducts electric power in the direction from the main electric power supply 50 toward the auxiliary electric power supply 100 due to the short-circuit failure (see an arrow of an alternate long and two short dashes line in FIG. 5), even in the case where the state of each of the second MOSFET 102 and the first MOSFET 101 is changed to the shut-off state. At this time, the second MOSFET 102 conducts electric current in the direction from the main electric power supply 50 toward the auxiliary electric power supply 100 through the parasitic diode D2. In this case, the flow of electric current from the main electric power supply 50 into the auxiliary electric power supply 100 cannot be restricted. According to the present embodiment, the third MOSFET 103 is provided on the first auxiliary electric power supply-side feed path L1 in addition to the second MOSFET 102, and the third MOSFET 103 includes the parasitic diode D2 that restricts the conduction of electric current in the direction from the main electric power supply 50 toward the auxiliary electric power supply 100. Even if the second MOSFET 102 undergoes a short-circuit failure, when the state of the third MOSFET 103 is switched to the shut-off state, the conduction of electric current from the main electric power supply 50 to the auxiliary electric power supply 100 is shut off (see arrows of solid lines in FIG. 5). Even in the case where the first MOSFET 101 undergoes a short-circuit failure, when the state of each of the second MOSFET 102 and the third MOSFET 103 is switched to the shut-off state, the flow of electric current from the main electric power supply 50 into the auxiliary electric power supply 100 can be restricted. Even in the case where the third MOSFET 103 undergoes a short-circuit failure, when the state of the second MOSFET 102 is switched to the shut-off state, the flow of electric current from the main electric power supply 50 into the auxiliary electric power supply 100 can be restricted. In this manner, even in the case where one of the MOSFETs undergoes a short-circuit failure, the flow of electric current from the main electric power supply 50 into the auxiliary electric power supply 100 can be restricted.
(2) The third MOSFET 103 is provided on the first auxiliary electric power supply-side feed path L1. Therefore, the on-resistance during feeding of electric power from the main electric power supply 50 to the steering control device 30 can be made smaller than in the case where the third MOSFET 103 is provided on the main electric power supply-side feed path Lm.
(3) If there is no second auxiliary electric power supply-side feed path L2 on which the fourth to sixth MOSFETs 104 to 106 are provided, when the first MOSFET 101 undergoes an open failure, electric current cannot be conducted from the auxiliary electric power supply 100 to the steering control device 30 even in the case where the state of each of the second MOSFET 102 and the third MOSFET 103 is switched to the fed state. In this state, even when an attempt is made to feed electric power from the auxiliary electric power supply 100, electric power cannot be fed to the steering control device 30. According to the present embodiment, the second auxiliary electric power supply-side feed path L2 is provided between the auxiliary electric power supply 100 and the steering control device 30, separately from the first auxiliary electric power supply-side feed path L1. Therefore, when the first MOSFET 101 undergoes an open failure, electric power can be fed from the auxiliary electric power supply 100 to the steering control device 30 through the second auxiliary electric power supply-side feed path L2. When the fourth MOSFET 104 undergoes an open failure, electric power can be fed from the auxiliary electric power supply 100 to the steering control device 30 through the first auxiliary electric power supply-side feed path L1. When one of the second MOSFET 102, the third MOSFET 103, the fifth MOSFET 105, and the sixth MOSFET 106 undergoes an open failure, electric power can be fed from the auxiliary electric power supply 100 to the steering control device 30 through at least one of the first auxiliary electric power supply-side feed path L1 and the second auxiliary electric power supply-side feed path L2. In this manner, even when one of the MOSFETs undergoes an open failure, the conduction of electric current from the auxiliary electric power supply 100 to the steering control device 30 can be realized.
(4) According to the present embodiment, even when one of the seventh to tenth MOSFETs 107 to 110 undergoes a short-circuit failure, the flow of electric current from the main electric power supply 50 into the auxiliary electric power supply 100 can be restricted. Even when one of the seventh to tenth MOSFETs 107 to 110 undergoes an open failure, the conduction of electric current from the main electric power supply 50 to the steering control device 30 can be realized.
(5) According to the present embodiment, it is possible to provide the electric power supply device 40 that can restrict the flow of electric current from the main electric power supply 50 into the auxiliary electric power supply 100 even when one of the MOSFETs undergoes a short-circuit failure.

The above-mentioned embodiment may be changed as follows. The following other embodiments can be combined with each other within such a range that no technical contradiction occurs. The ninth MOSFET 109 and the tenth MOSFET 110 may not be provided in the electric power supply circuit 41. That is, the main electric power supply-side feed path Lm may include only the first main electric power supply-side feed path L3. In this case, even when one of the MOSFETs undergoes a short-circuit failure, the flow of electric current from the main electric power supply 50 into the auxiliary electric power supply 100 can be restricted.

The fourth to sixth MOSFETs 104 to 106 may not be provided in the electric power supply circuit 41. That is, the auxiliary electric power supply-side feed path Ls may include only the first auxiliary electric power supply-side feed path L1. In this case, even when one of the MOSFETs undergoes a short-circuit failure, the flow of electric current from the main electric power supply 50 into the auxiliary electric power supply 100 can be restricted.

The third MOSFET 103 and the sixth MOSFET 106 may be provided on the main electric power supply-side feed path Lm. In this case, a MOSFET that is identical in configuration to the seventh MOSFET 107 may be provided on the first main electric power supply-side feed path L3, and a MOSFET that is identical in configuration to the ninth MOSFET 109 may be provided on the second main electric power supply-side feed path L4. For example, even when the seventh MOSFET 107 undergoes a short-circuit failure, the conduction of electric current from the main electric power supply 50 to the steering control device 30 can be restricted by the MOSFET that is identical in configuration to the seventh MOSFET 107. The third MOSFET 103 and the sixth MOSFET 106 may be provided on the main electric power supply-side feed path Lm as well as the auxiliary electric power supply-side feed path Ls.

The manner in which the MOSFETs are arranged on the main electric power supply-side feed path Lm can be appropriately changed as long as an effect similar to that of the above-mentioned embodiment is obtained. The manner in which the MOSFETs are arranged on the auxiliary electric power supply-side feed path Ls can be appropriately changed as long as an effect similar to that of the above-mentioned embodiment is obtained.

When electric current is conducted from the main electric power supply 50 to the steering control device 30, the electric current is conducted from both the first main electric power supply-side feed path L3 and the second main electric power supply-side feed path L4. However, the electric current may be conducted from only one of the first main electric power supply-side feed path L3 and the second main electric power supply-side feed path L4. When electric current is conducted from the auxiliary electric power supply 100 to the steering control device 30, the electric current is conducted from both the first auxiliary electric power supply-side feed path L1 and the second auxiliary electric power supply-side feed path L2. However, the electric power may be conducted from only one of the first auxiliary electric power supply-side feed path L1 and the second auxiliary electric power supply-side feed path L2.

The determination on abnormalities of the first to tenth MOSFETs is not limited to the above-mentioned determination in which the intermediate potentials Vm1 to Vm6 are used, but can be appropriately changed into a determination based on a comparison among the intermediate potentials Vm1 to Vm6, a determination in which the intermediate potentials Vm1 to Vm6 are not used, or the like.

The determination on abnormalities of the first to tenth MOSFETs 101 to 110 does not necessarily need to be made during the initial check, and may be intermittently made during the period in which the switch for starting the vehicle is on. Each of the first to sixth MOSFETs 101 to 106 may be a P-channel MOSFET. Each of the seventh to tenth MOSFETs 107 to 110 may be an N-channel MOSFET.

In the above-mentioned embodiment, the steering system 1 to which the electric power supply device 40 is applied is configured as the electric power steering system including the motor 20 coupled to the steering shaft 12 via the reducer 21, but may be configured as an electric power steering system including the motor 20 coupled to the rack shaft 14 via the reducer 21. The electric power supply device 40 does not necessarily need to be applied to an electric power steering system, and may be applied to, for example, a steer-by-wire steering system.

The electric power supply device 40 may feed electric power to an airbag device, a brake device, and the like. Alternatively, the electric power supply device 40 may feed electric power to a control apparatus for an automated guided vehicle, an electric vehicle, or the like.

## Claims

1. An electric power supply circuit that is provided with a main electric power supply-side feed path as a feed path for feeding electric power from a main electric power supply to a feed target, and an auxiliary electric power supply-side feed path as a feed path for feeding the electric power from an auxiliary electric power supply (100) to the feed target, the auxiliary electric power supply-side feed path being connected to the main electric power supply-side feed path, the electric power supply circuit **characterized by** comprising:
the auxiliary electric power supply (100) that is connected to the feed target through the auxiliary electric power supply-side feed path;
a first MOSFET (101) that is provided on the auxiliary electric power supply-side feed path, the first MOSFET (101) including a parasitic diode configured to restrict conduction of electric current in a direction from the auxiliary electric power supply (100) toward the feed target, and the first MOSFET (101) being configured to switch between a fed state where the electric power is fed to the feed target and a shut-off state where feed of the electric power is shut off;
a second MOSFET (102) that is provided on the auxiliary electric power supply-side feed path, the second MOSFET (102) including a parasitic diode configured to restrict conduction of the electric current in a direction from the feed target toward the auxiliary electric power supply (100), and the second MOSFET (102) being configured to switch between the fed state where the electric power is fed to the feed target and the shut-off state where the feed of the electric power is shut off; and
a third MOSFET (103) that is provided on at least one of the auxiliary electric power supply-side feed path and the main electric power supply-side feed path, the third MOSFET (103) including a parasitic diode configured to restrict conduction of the electric current in a direction from the main electric power supply toward the auxiliary electric power supply (100), the third MOSFET (103) being configured to switch between the fed state where the electric power is fed to the feed target and the shut-off state where the feed of the electric power is shut off.

2. The electric power supply circuit according to claim 1, **characterized in that** the third MOSFET (103) is provided on the auxiliary electric power supply-side feed path.

3. The electric power supply circuit according to claim 2, **characterized in that**:
the auxiliary electric power supply-side feed path includes a first auxiliary electric power supply-side feed path and a second auxiliary electric power supply-side feed path;
the first auxiliary electric power supply-side feed path and the second auxiliary electric power supply-side feed path are provided in parallel with each other;
the first MOSFET (101), the second MOSFET (102), and the third MOSFET (103) are provided on the first auxiliary electric power supply-side feed path;
the electric power supply circuit further includes
a fourth MOSFET (104) that includes a parasitic diode configured to restrict the conduction of the electric current in the direction from the auxiliary electric power supply (100) toward the feed target, the fourth MOSFET (104) being configured to switch between the fed state where the electric power is fed to the feed target and the shut-off state where the feed of the electric power is shut off,
a fifth MOSFET (105) that includes a parasitic diode configured to restrict the conduction of the electric current in the direction from the feed target toward the auxiliary electric power supply (100), the fifth MOSFET (105) being configured to switch between the fed state where the electric power is fed to the feed target and the shut-off state where the feed of the electric power is shut off, and
a sixth MOSFET (106) that includes a parasitic diode configured to restrict the conduction of the electric current in the direction from the main electric power supply toward the auxiliary electric power supply (100), the sixth MOSFET (106) being configured to switch between the fed state where the electric power is fed to the feed target and the shut-off state where the feed of the electric power is shut off; and
the fourth MOSFET (104), the fifth MOSFET (105), and the sixth MOSFET (106) are provided on the second auxiliary electric power supply-side feed path.

4. The electric power supply circuit according to any one of claims 1 to 3, **characterized in that**:
the main electric power supply-side feed path includes a first main electric power supply-side feed path and a second main electric power supply-side feed path;
the first main electric power supply-side feed path and the second main electric power supply-side feed path are provided in parallel with each other;
a seventh MOSFET (107) and an eighth MOSFET (108) are provided on the first main electric power supply-side feed path, the seventh MOSFET (107) including a parasitic diode configured to restrict conduction of the electric current in a direction from the main electric power supply toward the feed target, the seventh MOSFET (107) being configured to switch between the fed state where the electric power is fed to the feed target and the shut-off state where the feed of the electric power is shut off, the eighth MOSFET (108) including a parasitic diode configured to restrict conduction of the electric current in a direction from the feed target toward the main electric power supply, and the eighth MOSFET (108) being configured to switch between the fed state where the electric power is fed to the feed target and the shut-off state where the feed of the electric power is shut off; and
a ninth MOSFET (109) and a tenth MOSFET (110) are provided on the second main electric power supply-side feed path, the ninth MOSFET (109) including a parasitic diode configured to restrict the conduction of the electric current in the direction from the main electric power supply toward the feed target, the ninth MOSFET (109) being configured to switch between the fed state where the electric power is fed to the feed target and the shut-off state where the feed of the electric power is shut off, the tenth MOSFET (110) including a parasitic diode configured to restrict the conduction of the electric current in the direction from the feed target toward the main electric power supply, the tenth MOSFET (110) being configured to switch between the fed state where the electric power is fed to the feed target and the shut-off state where the feed of the electric power is shut off.

5. An electric power supply device **characterized by** comprising:
the electric power supply circuit according to any one of claims 1 to 4; and
a control unit (42) configured to control switching between the fed state and the shut-off state, wherein the feed target is a steering system configured to apply power to a steering mechanism of a vehicle.
